# EUROPEAN PATENT APPLICATION

(11) **EP 2 608 275 A1**
(43) Date of publication of application: **26.06.2013**
(21) Application number: 11818099.1
(22) Date of filing: 09.08.2011
(51) Int. Cl.: H01L 31/042, H01L 31/04

(54) **OPEN-CIRCUIT VOLTAGE CONTROL SYSTEM**

(30) Priority: 20.08.2010 JP 2010185569
(71) Applicant: Kabushiki Kaisha Toshiba, Minato-ku Tokyo 105-8001 (JP)
(72) Inventor: KAWAMATA, Kenji, Tokyo 105-8001 (JP)
(74) Representative: HOFFMANN EITLE
(86) International application number: PCT/JP2011/068129
(87) International publication number: WO 2012/023457

(57) **Abstract**

An open-circuit voltage control system which is used in a photovoltaic power system that includes a string 7 that includes solar battery panels connected in series and a switch 5 that connects and disconnects a path for supplying a direct-current voltage generated at the string to a load and which controls an open-circuit voltage of the string and which includes an open-circuit voltage measurement device 3 which measures an open-circuit voltage of the string in an open state where the string and the load are not connected to each other, a drive control device 11 which controls an output voltage from the solar battery panels, and a calculation control device 4 which outputs a signal for controlling the drive control device so that the open-circuit voltage may reach a specific voltage value not lower than an operable voltage of the load but lower than a breakdown voltage of the photovoltaic power system based on the open-circuit voltage measured by the open-circuit voltage measurement device, with the string and the load being in the open state.

## Description

### Technical Field

Embodiments of the present invention relate to an open-circuit voltage control system which is used in a photovoltaic power system and controls an open-circuit voltage so that the open-circuit voltage may reach a desired value.

### Background Art

Recently, power generation systems using natural energy have been attracting attention and more and more photovoltaic power systems are being introduced actively. Photovoltaic generation uses a solar (photovoltaic [PV]) battery that converts solar energy into electric power. However, a solar battery panel does not satisfy an operable voltage of a power conditioner. Therefore, in a photovoltaic power system disclosed in patent document 1, a plurality of solar battery panels are used in such a manner that they are connected in series.

### Prior Art Document

### Patent Document

Patent document 1: Jpn. Pat. Appln. KOKAI Publication No. 2001-84343

### Brief Description of the Drawing

FIG. 1 is a diagram showing the configuration of an open-circuit voltage control system according to this embodiment;
FIG. 2 is a diagram showing a photovoltaic power system using an open-circuit voltage control system according to a first embodiment;
FIG. 3 is a diagram to explain an operation of a solar-battery-panel sunlight transmission amount varying device according to the first embodiment;
FIG. 4 is a flowchart to explain a schematic procedure for processing performed by a calculation control device according to the first embodiment;
FIG. 5 is a graph showing the relationship between the amount of sunlight and an open-circuit voltage at each cell temperature of a solar battery panel;
FIG. 6 shows a result obtained by applying the open-circuit voltage control system of the first embodiment;
FIG. 7 is a diagram showing a photovoltaic power system using an open-circuit voltage control system according to a second embodiment;
FIG. 8 is a side view and a back view of a solar-battery-panel direction varying device according to the second embodiment;
FIG. 9 is a flowchart to explain a schematic procedure for processing performed by a calculation control device according to the second embodiment;
FIG. 10 shows a result obtained by applying the open-circuit voltage control system of the second embodiment;
FIG. 11 is a diagram showing a photovoltaic power system using an open-circuit voltage control system according to a third embodiment;
FIG. 12 is a diagram to explain an operation of a solar-battery-panel temperature varying device according to the third embodiment;
FIG. 13 is a flowchart to explain a schematic procedure for processing performed by a calculation control device according to the third embodiment;
FIG. 14 is a graph showing the relationship between the amount of sunlight and an open-circuit voltage at each cell temperature of a solar battery panel;
FIG. 15 shows a result obtained by applying the open-circuit voltage control system of the third embodiment;
FIG. 16 is a diagram showing a photovoltaic power system using an open-circuit voltage control system according to a fourth embodiment;
FIG. 17 is a flowchart to explain a schematic procedure for processing performed by a calculation control device according to the fourth embodiment;
FIG. 18 is a graph showing the relationship between the amount of sunlight and an open-circuit voltage at each cell temperature of a solar battery panel;
FIG. 19 is a schematic diagram showing the way the number of solar battery panels is changed by a circuit varying device;
FIG. 20 shows a result obtained by applying the open-circuit voltage control system of the fourth embodiment;
FIG. 21 shows a configuration of a photovoltaic power system;
FIG. 22 is a diagram to explain the number of connected solar battery panels per string in the photovoltaic power system;
FIG. 23 is a schematic diagram showing a string voltage and an inverter operating time in the photovoltaic power system; and
FIG. 24 is a diagram showing the transition of a voltage output from a solar battery panel.

Best Mode of Carrying Out the Invention Before explanation of a photovoltaic power system of this embodiment, functions a photovoltaic power system needs to have to address the aforementioned needs will be explained.

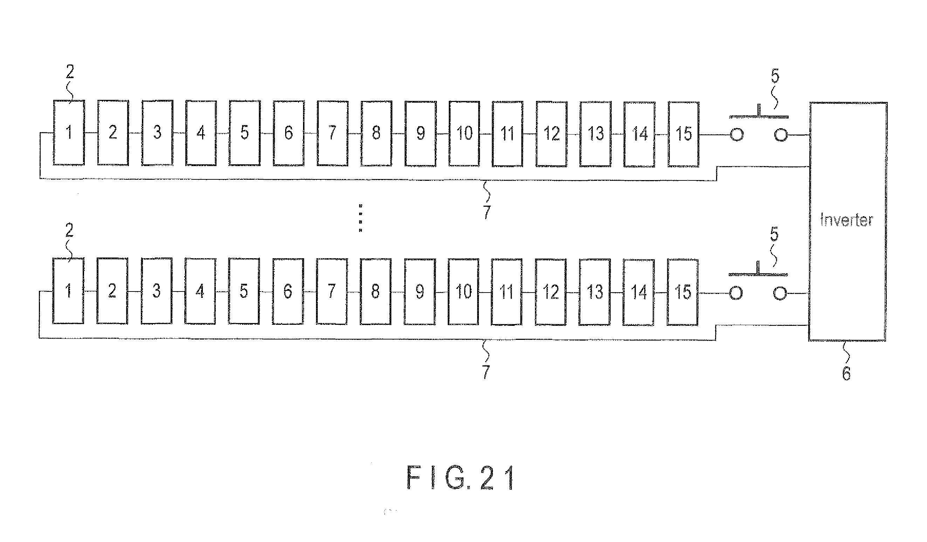

FIG. 21 shows the configuration of a photovoltaic power system.

The photovoltaic power system comprises a solar battery panel 2, a string wire 7, a switch 5, and an inverter 6.

The solar battery panel 2 is so formed that solar batteries (cells) with a photovoltaic effect are arranged in, for example, a planar form. The string wire 7 connects a plurality of solar battery panels 2 in series. The configuration of the solar battery panels 2 connected in series by the string wire 7 is referred to as a string. The inverter 6, which connects with at least one string, converts the input direct-current power of the solar battery panels 2 into alternating current. The switch 5 connects/disconnects a power line between the string wire 7 and the inverter 6. The switch 5 may be incorporated in the inverter 6.

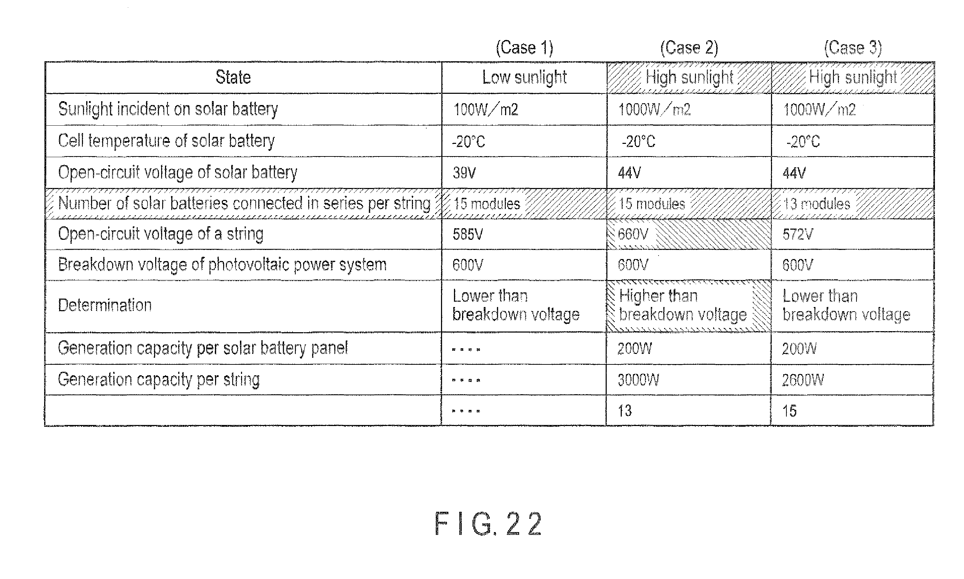

FIG. 22 is a diagram to explain the number of connected solar battery panels per string in the photovoltaic power system.

First, the main items in the leftmost column of FIG. 22 will be explained. The "sunlight incident on the solar battery" is the solar power (W) per unit area (m²). In this item, a small number indicates a small amount of sunlight; a large number, a large amount of sunlight. The "cell temperature of the solar battery" represents the operating temperature of a solar battery cell itself. For example, with a solar battery panel made of a silicon material, when the temperature of a solar battery cell is high, the generated voltage of the solar battery cell is low. When the temperature of the solar battery cell is low, the generated voltage of the solar battery cell is high. The open-circuit voltage of the solar battery is mostly dependent on the sunlight incident on the solar battery and the cell temperature of the solar battery. The "open-circuit voltage of the solar battery" is the output voltage of the solar battery cell when no load is connected to the solar battery cell.

Suppose the breakdown voltage of the photovoltaic power system is 600 V. Here, the breakdown voltage is a value determined as the upper limit of the generated voltage in each string. When the generated voltage in a string has exceeded the breakdown voltage, the component parts of the photovoltaic power system are damaged gradually though. Therefore, in the photovoltaic power system, a design not exceeding the breakdown voltage is desired.

In case 1, that is, a case where the sunlight incident on the solar battery is 100 W/m², the number of solar batteries connected in series per string is 15 modules. Therefore, the open-circuit voltage per string is 15 × 39 = 585 V, which is not higher than the breakdown voltage of 600 V.

In case 2, that is, a case where the sunlight incident on the solar battery is 1000 W/m², the number of solar batteries in series per string is 15 modules. Therefore, the open-circuit voltage per string is 15 × 44 = 660 V, which is higher than the breakdown voltage of 600 V.

Case 3 shows a configuration for avoiding such a breakdown-voltage-exceeded state. In case 3, suppose the number of solar batteries in series per string is 13 modules. Then, when the sunlight incident on the solar battery is 1000 W/m², the open-circuit voltage is 13 × 44 = 572 V, not higher than a breakdown voltage of 600 V. As shown in case 3, the number of solar batteries in series per string is determined (decreased) so as to fit an environment where the photovoltaic power system is installed, enabling the open-circuit voltage to be not higher than the breakdown voltage.

However, with this approach, the power generation capacity per string is 200 × 15 = 3000 W in case 2, whereas it decreases to 200 × 13 = 2600 W in case 3. Therefore, the number of strings needed to obtain an electricity generating capacity of 39000 W is 39000/3000 = 13 strings in case 2, whereas it increases to 39000/2600 = 15 strings in case 3. An increase in the number of strings leads to an increase in the number of string wires, resulting in an increase in the production cost of the photovoltaic power system.

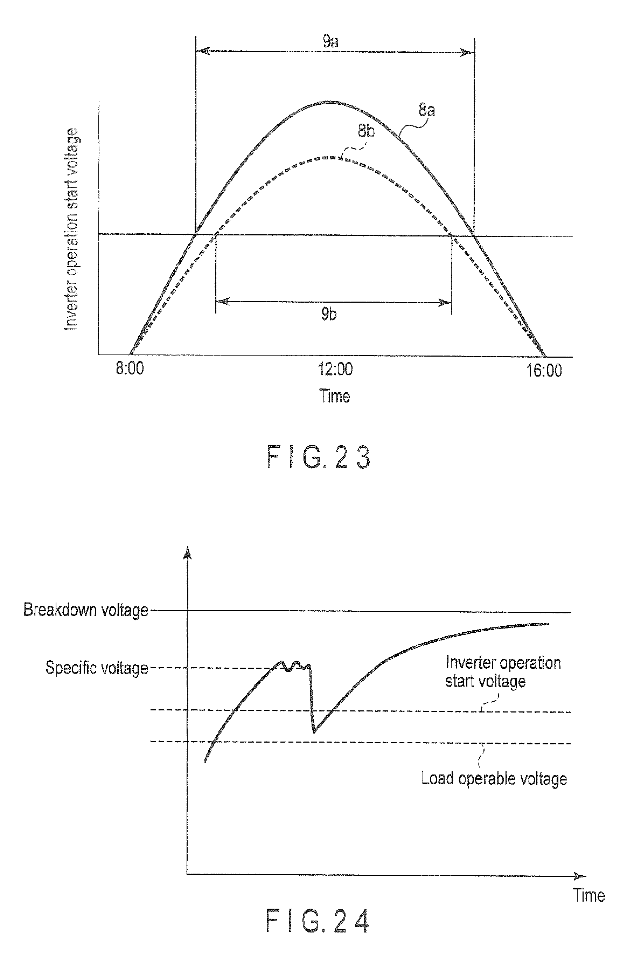

FIG. 23 is a schematic diagram showing a string voltage 8 and an inverter operating time 9 in the photovoltaic power system. The string voltage 8 is a generated voltage (open-circuit voltage) per string. The inverter 6 starts to operate when the string voltage 8 has exceeded an inverter operation start voltage and stops operating when the string voltage 8 has become lower than the inverter operation start voltage,

In the graph of FIG. 23, the string voltage 8 (8a, 8b) rises as the morning sun rises. When the string voltage 8 (8a, 8b) has exceeded a specific value, the inverter 6 starts to operate automatically. Then, when the sun has set and the string voltage 8 (8a, 8b) has become less than or equal to the specific value, the inverter 6 stops operating automatically. As shown in FIG. 23, the inverter operating time 9b when the number of solar batteries in series per string is smaller is shorter than the inverter operating time 9a when the number of solar batteries in series per string is larger. Therefore, the amount of electricity generated when the number of solar batteries in series per string is smaller is less than the amount of electricity generated when the number of solar batteries in series per string is larger.

As described above, in the photovoltaic power system, when the number of solar battery panels connected in series is limited, this result in an increase in the production cost and a decrease in the amount of electricity generated. Therefore, if the number of solar battery panels per string can be increased as compared with a conventional equivalent, or a decrease in the number of solar battery panels can be restricted, a decrease in the number of strings enables the cost to decrease further and the amount of electricity generated to increase.

The open-circuit voltage control system of the embodiment has been accomplished as a result of conducting such a technical examination repeatedly. Hereinafter, the open-circuit voltage control system of the embodiment will be explained with reference to the accompanying drawings.

### [First Embodiment]

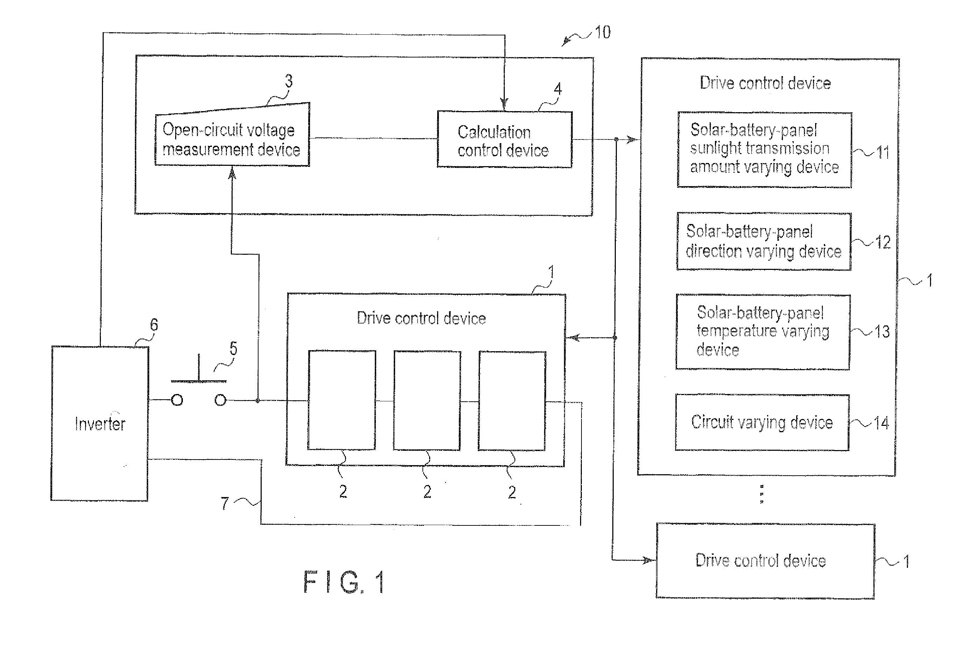

FIG. 1 is a diagram showing the configuration of an open-circuit voltage control system 10 according to a first embodiment. The open-circuit voltage control system 10 comprises an open-circuit voltage measurement device 3, a calculation control device 4, and a drive control device 1. The open-circuit voltage measurement device 3 measures a string voltage with no load applied, that is, an open-circuit voltage. The calculation control device 4 not only exchanges a signal with an inverter 6, but also receives a measurement signal from the open-circuit voltage measurement device 3 and controls the drive control device 1. The drive control device 1 drives a solar battery panel 2 and the like, thereby controlling the string voltage.

The drive control device 1 can be configured by using at least one of a solar-battery-panel sunlight transmission amount varying device 11, a solar-battery-panel direction varying device 12, a solar-battery-panel temperature varying device 13, and a circuit varying device 14.

As shown in FIG. 21, a plurality of strings can be connected to the inverter 6. The open-circuit voltage measurement device 3 and calculation control device 4 are configured to be common to a plurality of strings. The drive control device 1 is configured for each string. The open-circuit voltage measurement device 3, calculation control device 4, and drive control device 1 are not limited to the first embodiment and may be configured in various modes. For example, the open-circuit voltage measurement device 3 or calculation control device 4 may be configured for each string. In addition, the drive control device 1 may be configured to be common to strings.

In the first embodiment, the solar-battery-panel sunlight transmission amount varying device 11, which is used as the drive control device 1, varies the sunlight transmission amount, thereby adjusting the open-circuit voltage.

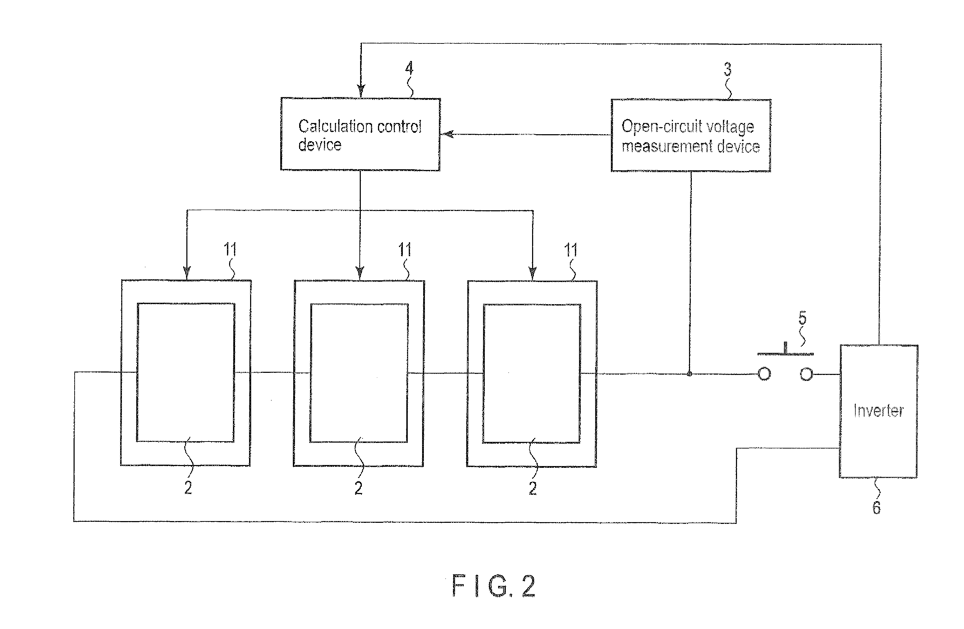

FIG. 2 is a diagram showing a photovoltaic power system using the open-circuit voltage control system 10 of the first embodiment. The photovoltaic power system comprises the solar battery panel 2, the open-circuit voltage measurement device 3, the calculation control device 4, the solar-battery-panel sunlight transmission amount varying device 11, a switch 5, and the inverter 6. The solar-battery-panel sunlight transmission amount varying device 11, which is provided between sunlight and the solar battery panel 2, adjusts the amount of sunlight passing through the device 11. An explanation of the devices excluding the solar-battery-panel sunlight transmission amount varying device 11 will be omitted.

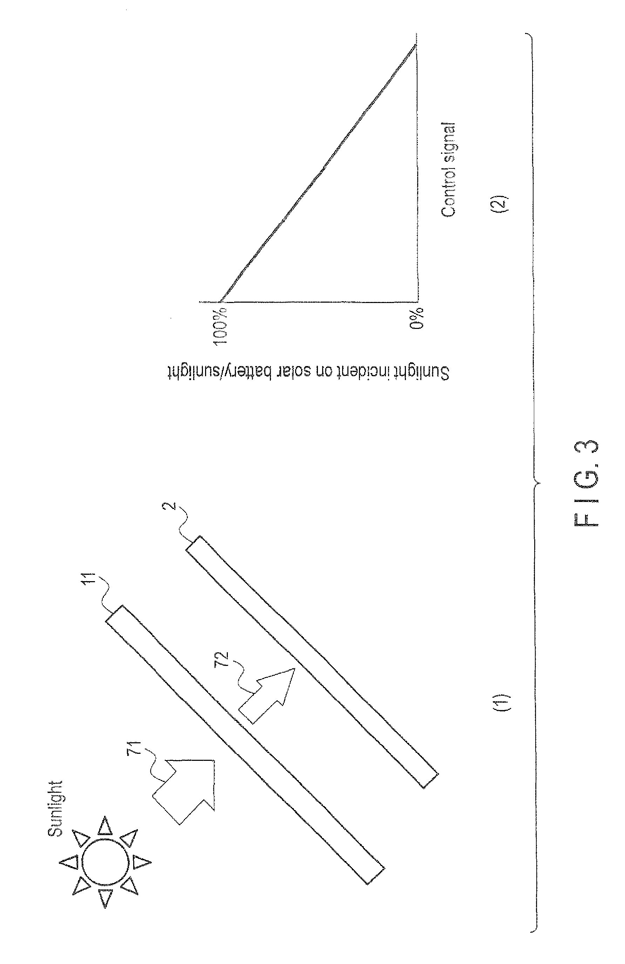

FIG. 3 is a diagram to explain an operation of the solar-battery-panel sunlight transmission amount varying device 11 according to the first embodiment. For example, a liquid-crystal shutter 111 is used as the solar-battery-panel sunlight transmission amount varying device 11 as shown in FIG. 3(1) and a control signal that changes the transmittance of the liquid-crystal shutter 111 as shown in FIG. 3(2) is supplied, thereby enabling the amount of sunlight incident on the solar battery panel 2 to be controlled. As a means for changing the sunlight transmission amount, a means for changing an aperture area may be used. For example, a light blocking member, such as a blind, may be provided in place of the liquid-crystal shutter 111 and its light-blocking area may be varied, thereby adjusting the amount of sunlight passing through the light blocking member.

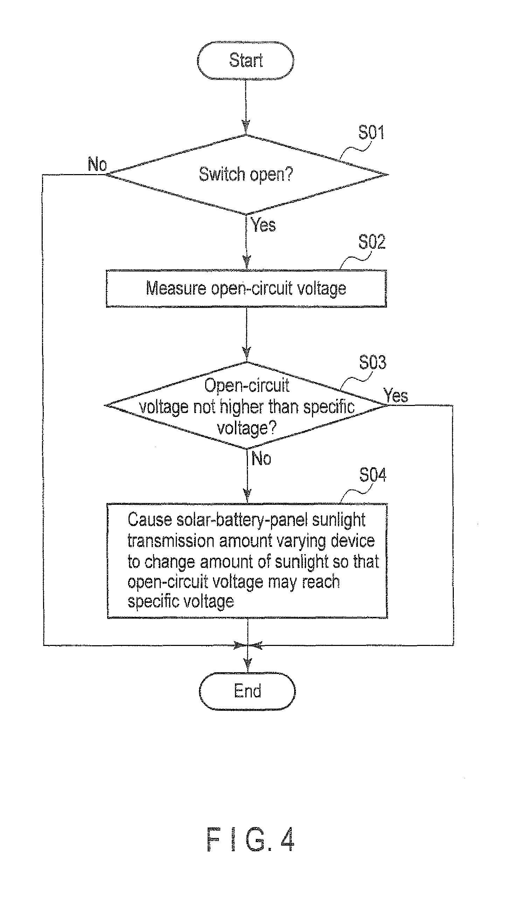

FIG. 4 is a flowchart to explain a schematic procedure for processing performed by the calculation control device 4 of the first embodiment. The calculation control device 4 performs the operation shown by the flowchart at specific intervals.

In step S01, the calculation control device 4 determines on the basis of a signal from the inverter 6 whether the switch 5 is open. As described above, the inverter 6 starts to operate when the string voltage 8 has exceeded the inverter operation start voltage. That is, when the string voltage 8 has exceeded the inverter operation start voltage, the inverter 6 brings the switch 5 into an ON operation, thereby causing an internal conversion circuit to take in the string voltage 8. Therefore, the open/closed state of the switch 5 is controlled by the inverter 6.

When the switch 5 is closed (No in step S01), the calculation control device 4 terminates the operation. When the switch 5 is open (Yes in step S01), the calculation control device 4, in step S02, takes in the open-circuit voltage measured at the open-circuit voltage measurement device 3 in step S02.

In step S03, the calculation control device 4 checks whether the open-circuit voltage is less than or equal to a specific voltage. The specific voltage is a voltage not lower than a voltage at which the load of the inverter can operate but lower than the breakdown voltage of the photovoltaic power system. The details of this will be described later. When the open-circuit voltage is less than or equal to the specific voltage (Yes in step S03), the calculation control device 4 terminates the operation. When the open-circuit voltage has exceeded the specific voltage (No in step S03), the calculation control device 4, in step S04, changes the aperture of the solar-battery-panel sunlight transmission amount varying device 11 so that the open-circuit voltage may reach the specific voltage.

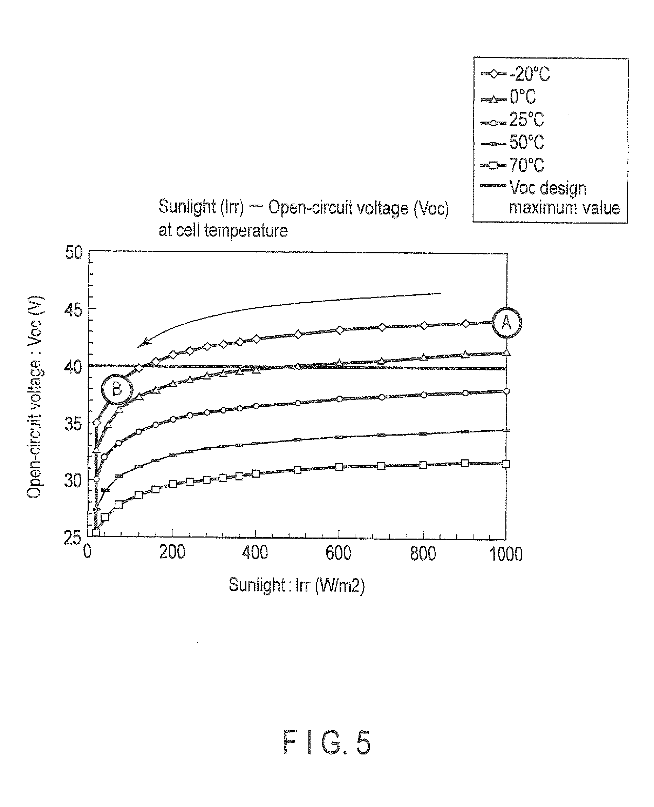

FIG. 5 is a graph showing the relationship between the amount of sunlight and an open-circuit voltage at each cell temperature of a solar battery panel. As shown in the graph, the open-circuit voltage gets lower as the amount of sunlight gets smaller. In addition, the open-circuit voltage gets lower as the cell temperature gets higher. In the graph, a cell voltage value corresponding to the breakdown voltage value of the open-circuit voltage is represented as 40 V.

Here, the meaning of this control method will be explained. It is conceivable that the output voltage of the solar battery panel 2 transits as follows after the morning sun has risen.

FIG. 24 is a diagram showing the transition of a voltage output from the solar battery panel. The morning sun illuminates the solar battery panel 2. As time passes, the open-circuit voltage of the solar battery panel 2 increases. The calculation control device 4 controls the aperture of the solar-battery-panel sunlight transmission amount varying device 11 so that the open-circuit voltage of the solar battery panel 2 may reach a specific voltage. The specific voltage is set higher than the inverter operation start voltage. However, the inverter 6 does not start to operate immediately after the open-circuit voltage has exceeded a starting voltage, but starts to operate after a specific time (e.g., several tens of minutes) has elapsed. Therefore, the calculation control device 4 continues control so that the open-circuit voltage may reach the specific voltage until the inverter 6 has started to operate.

Since a load is applied after the inverter 6 has started to operate, the voltage output from the solar battery panel gets lower under the influence of the load. Thereafter, a load control function of the inverter 6 controls the voltage of the solar battery panel 2 so that the power generated by the solar battery may get higher, thereby suppressing a rise in the open-circuit voltage of the solar battery panel. As described above, after the inverter 6 has started to operate, an attempt to suppress a rise in the string voltage 8 is made. From these, the breakdown voltage can be prevented from being exceeded by controlling the aperture of the light-blocking area so that a voltage immediately before the inverter 6 starts to operate may reach the specific voltage.

In this example, the specific voltage has been set at a voltage not lower than the inverter operation start voltage but lower than the breakdown voltage. An object to which the open-circuit voltage control system 10 is applied is not limited to the inverter 6. It may be applied to an ordinary load. Therefore, the specific voltage corresponds to setting to a voltage not lower than a voltage at which the load can operate but lower than the breakdown voltage.

The control operation performed by the calculation control device 4 may use such a control method as PID feedback control, sampling control, or sampling PI control. In addition, preset control may be used making use of the characteristic of FIG. 5 peculiar to the photovoltaic power system.

For example, a temperature sensor (not shown) is provided in the central part of the solar battery panel 2 and a cell temperature is measured as a representative. The calculation control device 4 determines a characteristic curve in FIG. 5 from cell temperatures measured by the temperature sensor. Then, the present amount X of sunlight incident on the solar battery panel 2 is ascertained on the characteristic curve from the open-circuit voltages measured by the open-circuit voltage measurement device 3. Next, the amount X of sunlight at which the open-circuit voltage reaches the specific voltage is found and the aperture is controlled so as to be Y/X times the present aperture.

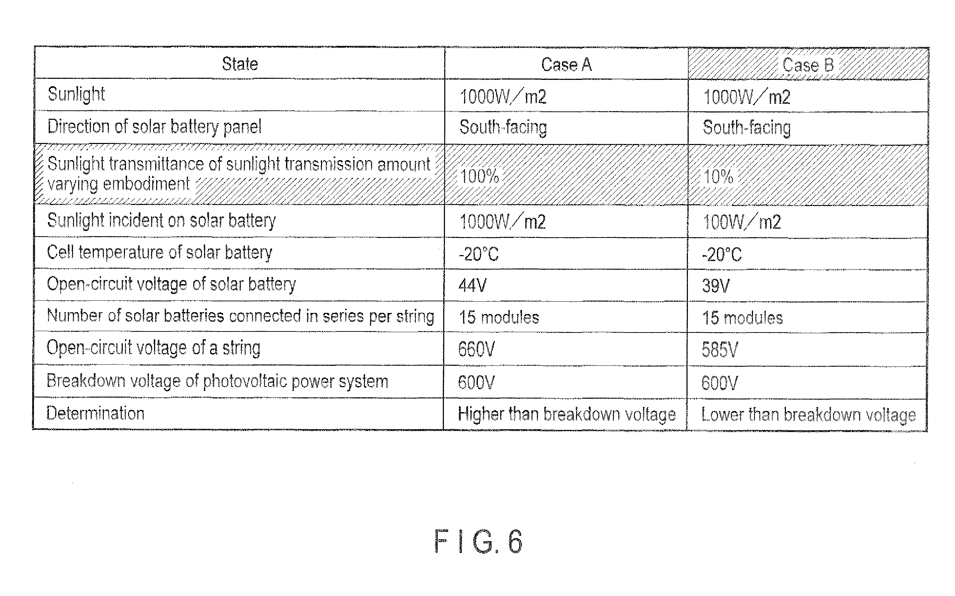

FIG. 6 shows a result obtained by applying the open-circuit voltage control system of the first embodiment. The amount of sunlight was 1000 W/m², the solar battery panel faced south, and the sunlight transmittance of the sunlight transmission amount varying device was at 100% (with no light blocking) in case A and 10% in case B. The open-circuit voltage of the solar battery was 44 V in case A and 39 V in case B.

The open-circuit voltage of a string is calculated from the open-circuit voltage of the solar battery and the number of solar batteries connected in series per string.

In case A, the amount of sunlight incident on the solar battery is 1000 W/m², the cell temperature is -20°C, and the number of solar batteries connected in series per string is 15, with the result that the open-circuit voltage of a string is 660 V. Therefore, if the breakdown voltage of the photovoltaic power system is 600 V, the open-circuit voltage has exceeded the breakdown voltage. In case B, the sunlight transmittance of the sunlight transmission amount varying device was controlled so as to reach 10%, with the result that the open-circuit voltage of a string was at 585 V, which was within the range of a breakdown voltage of 600 V of the photovoltaic power system.

While in the flowchart of FIG. 4, a control operation is not performed in step S03 when the open-circuit voltage is not higher than the specific value, the amount of sunlight may be increased in this case.

### [Second Embodiment]

In a second embodiment, a solar-battery-panel direction varying device 12 is used as a drive control device 1 and an open-circuit voltage is adjusted by varying the direction of a solar battery panel.

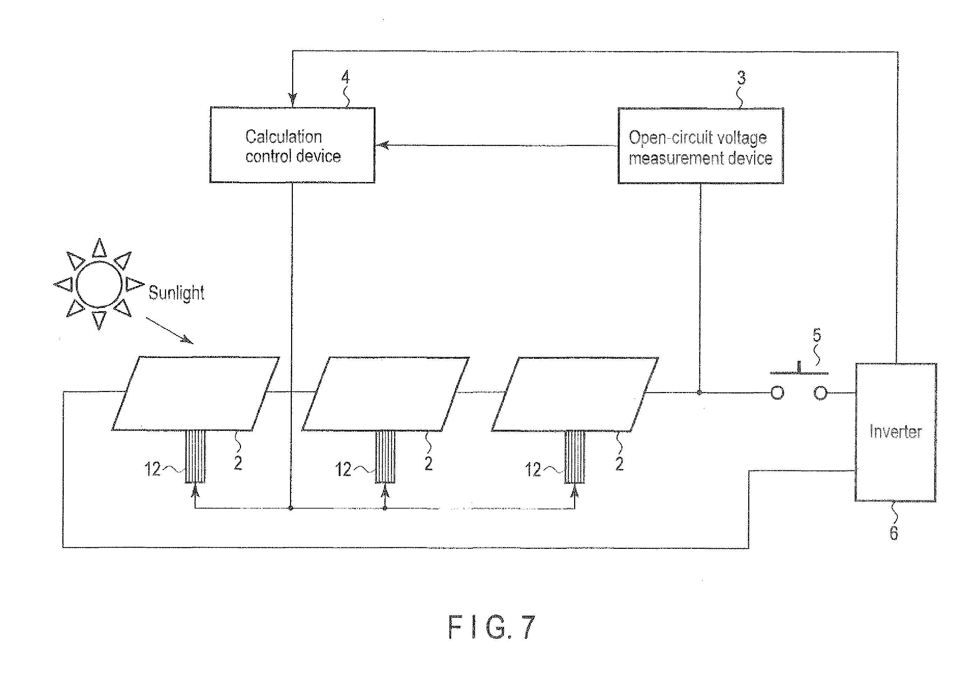

FIG. 7 is a diagram showing a photovoltaic power system using an open-circuit voltage control system 10 of the second embodiment. The photovoltaic power system comprises a solar battery panel 2, an open-circuit voltage measurement device 3, a calculation control device 4, a solar-battery-panel direction varying device 12, a switch 5, and an inverter 6. The solar-battery-panel direction varying device 12 adjusts the amount of sunlight incident on the solar battery panel. An explanation of the devices excluding the solar-battery-panel direction varying device 12 will be omitted,

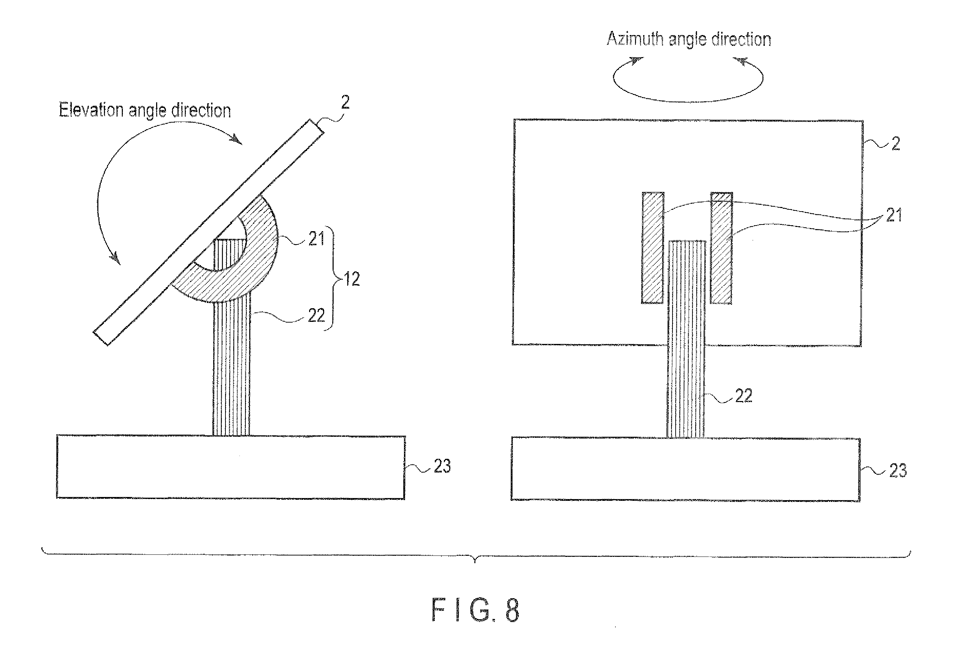

FIG. 8 is a side view and a back view of the solar-battery-panel direction varying device 12 according to the second embodiment. The solar-battery-panel direction varying device 12 changes the direction of the solar battery panel 2 that converts energy of sunlight into electric energy. The solar-battery-panel direction varying device 12 includes an azimuth angle varying device 22 that control an azimuth angle and an elevation angle varying device 21. Then, the solar-battery-panel direction varying device 12 is provided on a base 23 serving as a reference. Supplying a control signal to the solar-battery-panel direction varying device 12 enables the amount of sunlight incident on the solar battery panel 2 to be adjusted.

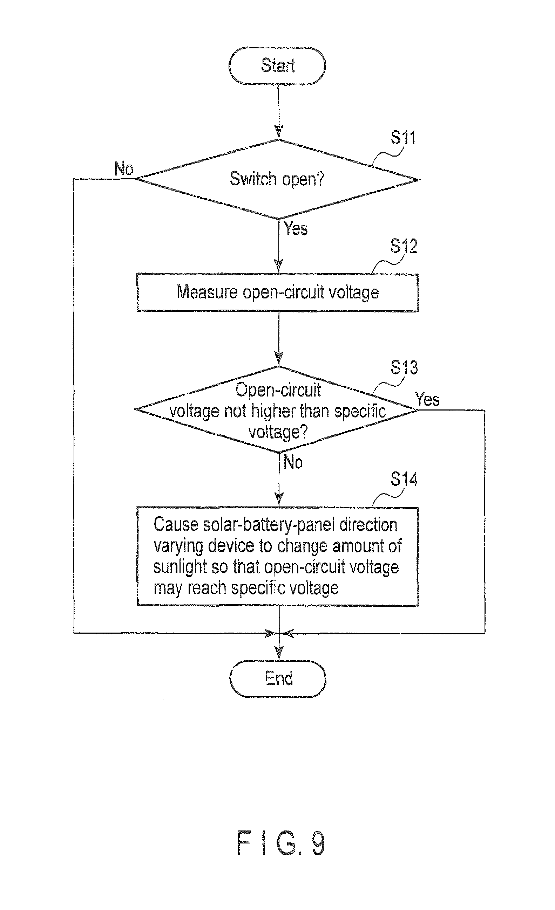

FIG. 9 is a flowchart to explain a schematic procedure for processing performed by the calculation control device 4 of the second embodiment. The calculation control device 4 performs the operations shown in the flowchart at specific intervals.

In step S11, the calculation control device 4 determines on the basis of a signal from the inverter 6 whether the switch 5 is open.

When the switch 5 is closed (No in step S11), the calculation control device 4 terminates the operation. When the switch 5 is open (Yes in step S11), the calculation control device 4, in step S12, takes in an open-circuit voltage measured by the open-circuit voltage measurement device 3.

In step S13, the calculation control device 4 checks whether the open-circuit voltage is less than or equal to a specific voltage. The specific voltage is a voltage not lower than a voltage at which the load of the inverter 6 can operate but lower than the breakdown voltage of the photovoltaic power system. The details of this have been already described and therefore will be omitted. When the open-circuit voltage is less than or equal to the specific voltage (Yes in step S13), the calculation control device 4 terminates the operation. When the open-circuit voltage has exceeded the specific voltage (No in step S13), the calculation control device 4, in step S14, changes the direction of the solar-battery-panel direction varying device 12 so that the open-circuit voltage may reach the specific voltage.

The direction of sunlight in a place where the solar-battery-panel direction varying device 12 has been installed is determined if the current year, month, day of the week, and the current time in hours and minutes are known. Therefore, on the basis of a previously-created database about the direction of sunlight, the direction of the solar-battery-panel direction varying device 12 is changed so as to decrease the amount of sunlight to a specific value. Both of the azimuth angle varying device 22 and the elevation angle varying device 21 may be operated. Alternatively, one of them may be operated and, if the result is insufficient, the other may be additionally operated.

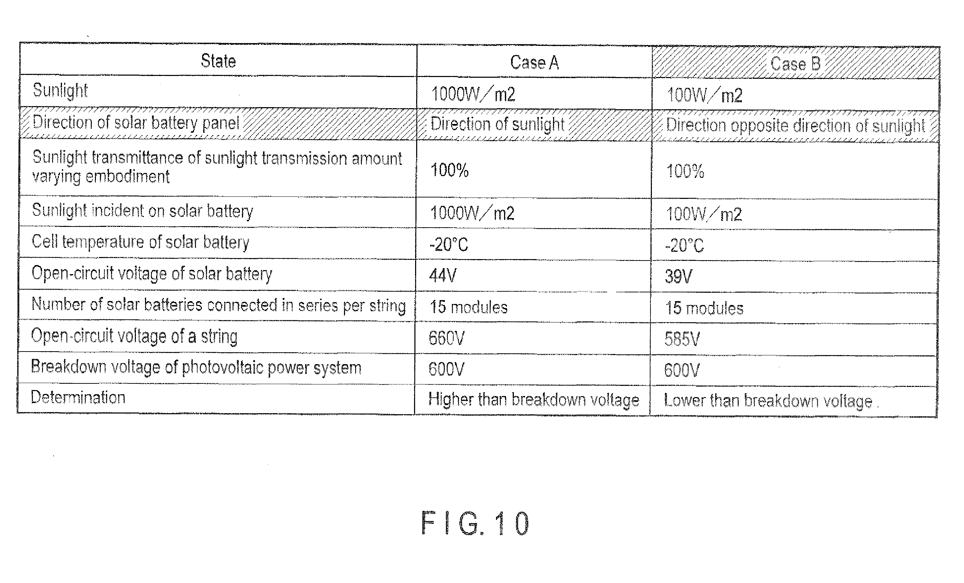

FIG. 10 shows a result obtained by applying the open-circuit voltage control system of the second embodiment. In case A, the amount of sunlight was at 1000 W/m², the solar battery panel faced the direction of sunlight, and the sunlight transmittance of the sunlight transmission amount varying device was at 100%. In case B, the amount of sunlight was at 100 W/m², the solar battery panel faced a direction opposite the direction of sunlight, and the sunlight transmittance was at 100%. The open-circuit voltage of the solar battery was 44 V in case A and 39 V in case B.

The open-circuit voltage of a string is calculated from the open-circuit voltage of the solar battery and the number of solar batteries connected in series per string.

In case A, the amount of sunlight incident on the solar battery is 1000 W/m², the cell temperature is -20°C, and the number of solar batteries connected in series per string is 15, with the result that the open-circuit voltage of a string is 660 V. Therefore, if the breakdown voltage of the photovoltaic power system is 600 V, the open-circuit voltage has exceeded the breakdown voltage. In case B, the solar-battery-panel direction varying device 12 was caused to control the amount of sunlight so as that the amount might reach 100 W/m², with the result that the open-circuit voltage of a string was at 585 V, which was within the range of a breakdown voltage of 600 V of the photovoltaic power system.

While in the flowchart of FIG. 9, a control operation is not performed in step S13 when the open-circuit voltage is less than or equal to the specific value, the amount of sunlight may be increased in this case.

### [Third Embodiment]

In a third embodiment, a solar-battery-panel temperature varying device 13 is used as a drive control device 1 and an open-circuit voltage is adjusted by varying a solar battery panel temperature.

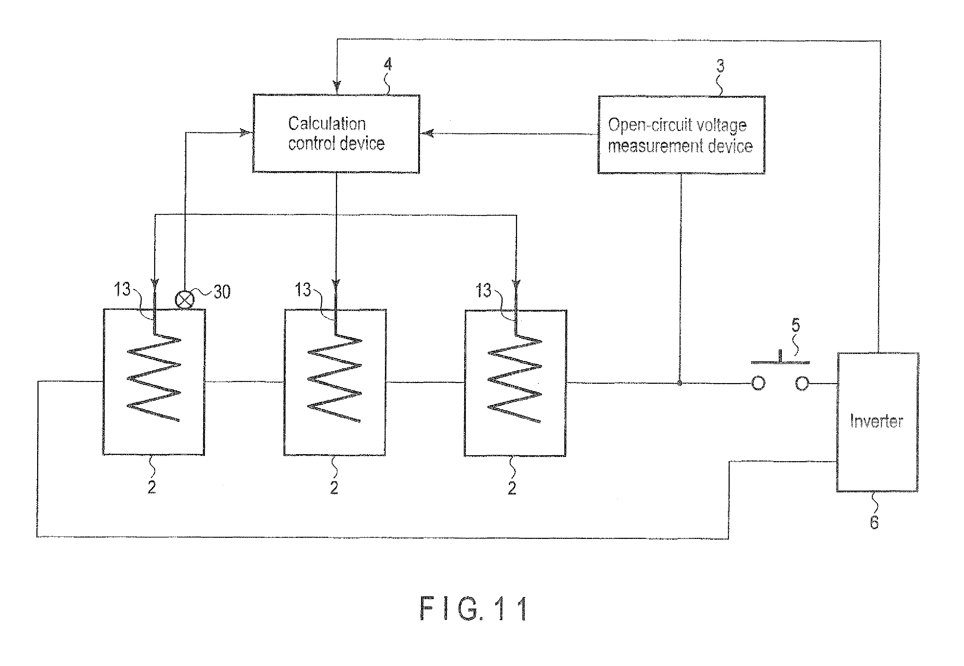

FIG. 11 is a diagram showing a photovoltaic power system using an open-circuit voltage control system 10 of the third embodiment. The photovoltaic power system comprises a solar battery panel 2, an open-circuit voltage measurement device 3, a calculation control device 4, a solar-battery-panel temperature varying device 13, a temperature sensor 30, a switch 5, and an inverter 6. The solar-battery-panel temperature varying device 13, which is installed adjacent to the solar battery panel 2, adjusts a panel temperature. The temperature sensor 30, which is provided in the central part of the solar battery panel 2, treats its measured value as a cell temperature. An explanation of the devices excluding the solar-battery-panel temperature varying device 13 and temperature sensor 30 will be omitted.

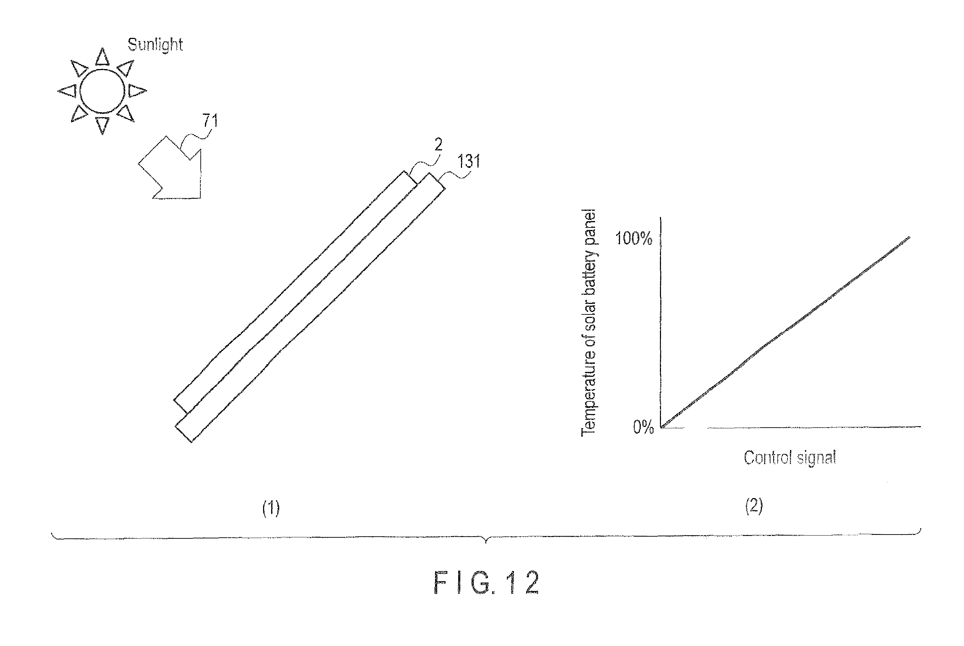

FIG. 12 is a diagram to explain an operation of the solar-battery-panel temperature varying device 13 of the third embodiment. As shown in FIG. 12(1), for example, a heating wire 131 is used as the solar-battery-panel temperature varying device 13. Supplying a current signal as a control signal as shown in FIG. 12(2) enables the cell temperature of the solar battery panel 2 to be controlled. Heated water may be used in place of the heading wire 131 as a means for controlling the cell temperature of the solar battery panel 2, thereby adjusting the cell temperature.

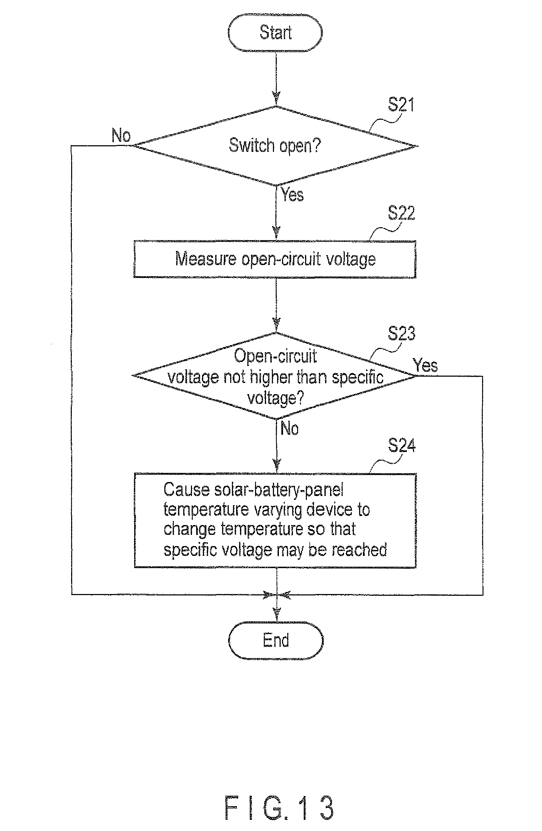

FIG. 13 is a flowchart to explain a schematic procedure for processing performed by the calculation control device 4 of the third embodiment. The calculation control device 4 performs the operations shown in the flowchart at specific intervals.

In step S21, the calculation control device 4 determines on the basis of a signal from the inverter 6 whether the switch 5 is open.

When the switch 5 is closed (No in step S21), the calculation control device 4 terminates the operation. When the switch 5 is open (Yes in step S21), the calculation control device 4, in step S22, takes in an open-circuit voltage measured by the open-circuit voltage measurement device 3.

In step S23, the calculation control device 4 checks whether the open-circuit voltage is less than or equal to a specific voltage. The specific voltage is a voltage not lower than a voltage at which the load of the inverter 6 can operate but lower than the breakdown voltage of the photovoltaic power system. The details of this have been already described and therefore will be omitted. When the open-circuit voltage is less than or equal to the specific voltage (Yes in step S23), the calculation control device 4 terminates the operation. When the open-circuit voltage has exceeded the specific voltage (No in step S23), the calculation control device 4, in step S24, causes the solar-battery-panel temperature varying device 13 to change the temperature of the solar battery panel 2 so that the open-circuit voltage may reach the specific voltage.

In the control method for the third embodiment, each method described in the first embodiment can be used. For example, control may be performed as follows.

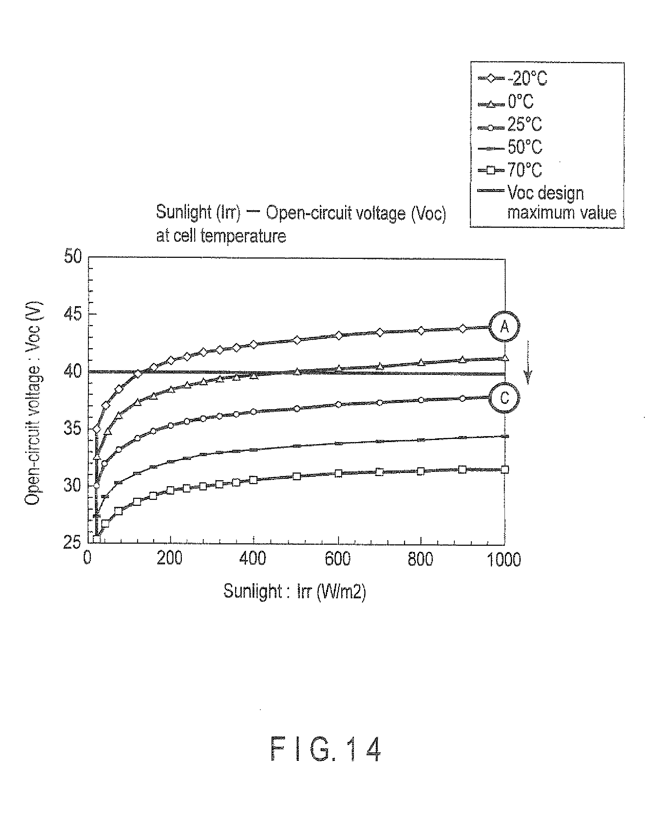

FIG. 14 is a graph showing the relationship between the amount of sunlight and an open-circuit voltage at each cell temperature of a solar battery panel. As shown in the graph, as the amount of sunlight gets smaller, the open-circuit voltage gets lower. In addition, as the cell temperature gets higher, the open-circuit voltage gets lower. In the graph, the cell voltage value corresponding to the breakdown voltage value of the open-circuit voltage is represented as 40 V.

The calculation control device 4 determines a characteristic curve of FIG. 14 from cell temperatures measured by the temperature sensor 30. Then, the present amount of sunlight incident on the solar battery panel 2 is ascertained on the characteristic curve from the open-circuit voltages measured by the open-circuit voltage measurement device 3. Then, a target cell temperature for causing the open-circuit voltage to reach the specific voltage at the amount of sunlight is found and the solar-battery-panel temperature varying device 13 performs control so as to cause the target cell temperature to be reached.

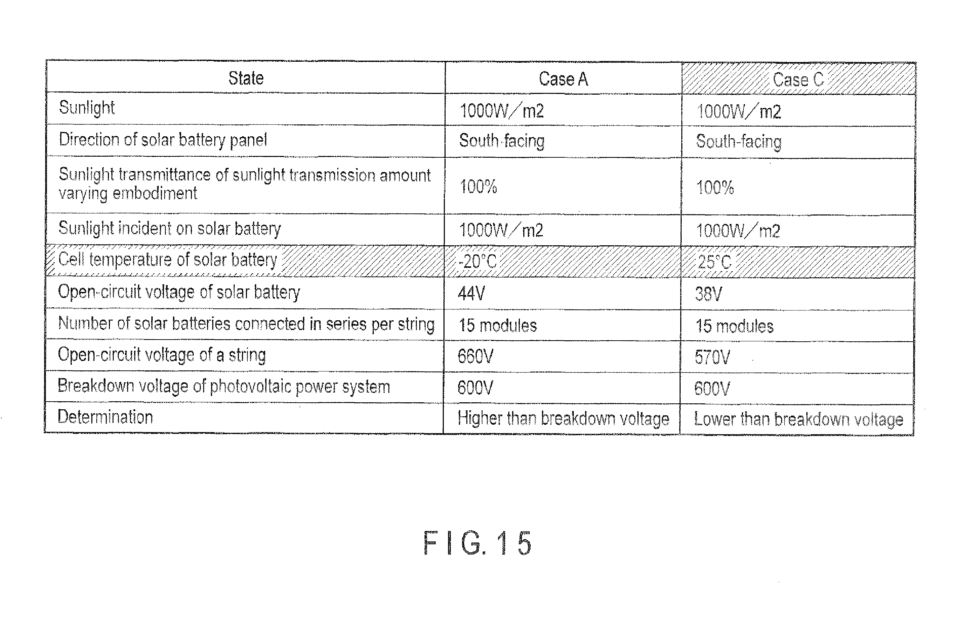

FIG. 15 shows a result obtained by applying the open-circuit voltage control system of the third embodiment. In case A, the amount of sunlight was 1000 W/m², the solar battery panel faced south, and the sunlight transmittance of the sunlight transmission amount varying device was at 100%. The open-circuit voltage of the solar battery was 44 V in case A.

The open-circuit voltage of a string is calculated from the open-circuit voltage of the solar battery and the number of solar batteries connected in series per string. In case A, the amount of sunlight incident on the solar battery is 1000 W/m², the cell temperature is -20°C, and the number of solar batteries connected in series per string is 15, with the result that the open-circuit voltage of a string is 660 V. Therefore, if the breakdown voltage of the photovoltaic power system is 600 V, the open-circuit voltage has exceeded the breakdown voltage.

As in case A, in case C, the amount of sunlight is 1000 W/m², the solar battery panel faces south, and the sunlight transmittance of the sunlight transmission amount varying device is 100%. The solar-battery-panel temperature varying device 13 controlled the cell temperature so that the cell temperature might reach 25°C, with the result that the open-circuit voltage of a string was at 570 V, which was within the range of a breakdown voltage of 600 V of the photovoltaic power system.

### [Fourth Embodiment]

In a fourth embodiment, an open-circuit voltage is adjusted by varying the number of connected solar battery panels constituting a circuit as a drive control device 1.

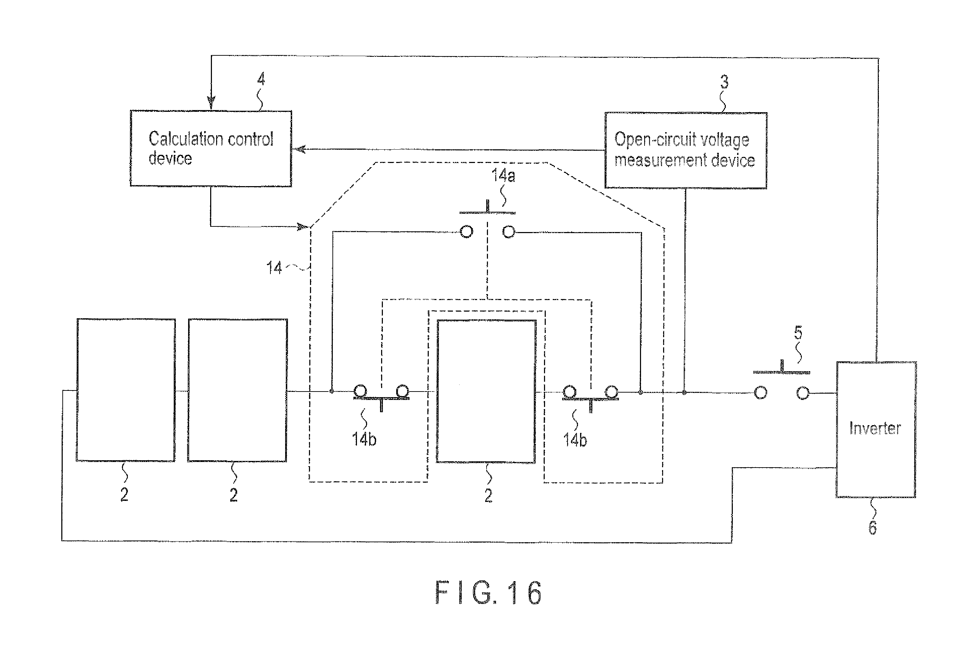

FIG. 16 is a diagram showing a photovoltaic power system using an open-circuit voltage control system 10 of the fourth embodiment. The photovoltaic power system comprises a solar battery panel 2, an open-circuit voltage measurement device 3, a calculation control device 4, a circuit varying device 14, a switch 5, and an inverter 6. The circuit varying device 14 changes the number of solar battery panels connected to a string.

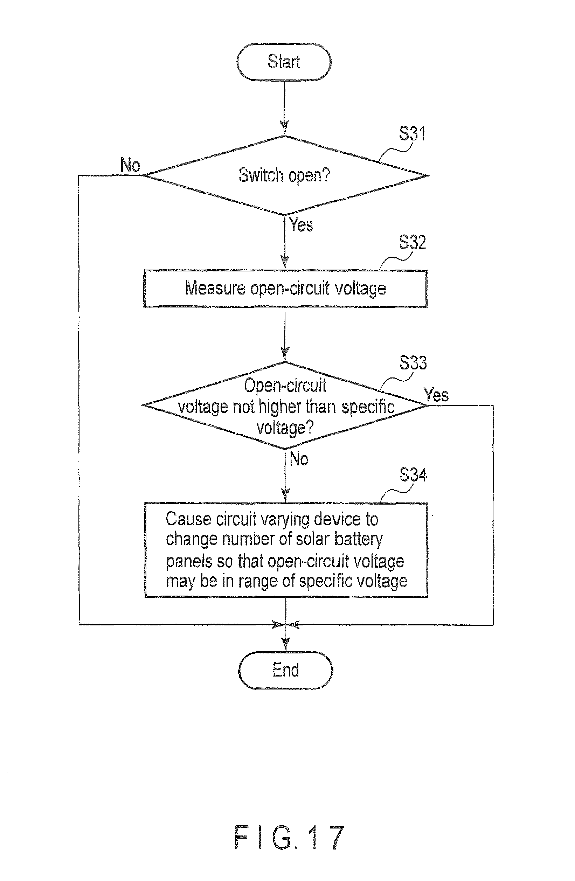

FIG. 17 is a flowchart to explain a schematic procedure for processing performed by the calculation control device 4 of the fourth embodiment. The calculation control device 4 performs the operations shown in the flowchart at specific intervals.

In step S31, the calculation control device 4 determines on the basis of a signal from the inverter 6 whether the switch 5 is open.

When the switch 5 is closed (No in step S31), the calculation control device 4 terminates the operation. When the switch 5 is open (Yes in step S31), the calculation control device 4, in step S32, takes in an open-circuit voltage measured by the open-circuit voltage measurement device 3.

In step S33, the calculation control device 4 checks whether the open-circuit voltage is less than or equal to a specific voltage. The specific voltage is a voltage not lower than a voltage at which the load of the inverter 6 can operate but lower than the breakdown voltage of the photovoltaic power system. The details of this are the same as those in the first embodiment and therefore an explanation of them will be omitted. When the open-circuit voltage is less than or equal to the specific voltage (Yes in step S33), the calculation control device 4 terminates the operation. When the open-circuit voltage has exceeded the specific voltage (No in step S33), the calculation control device 4, in step S34, causes the circuit varying device 14 to change the number of solar battery panels connected to a string so that the open-circuit voltage may be not lower than the inverter operation start voltage but lower than the breakdown voltage.

For example, when the open-circuit voltage has exceeded the specific voltage, the calculation control device 4 has only to change (or decrease) the number of solar battery panels 2. In addition, the solar battery panel may be provided with a thermometer (not shown), enabling the open-circuit voltage to be controlled as follows.

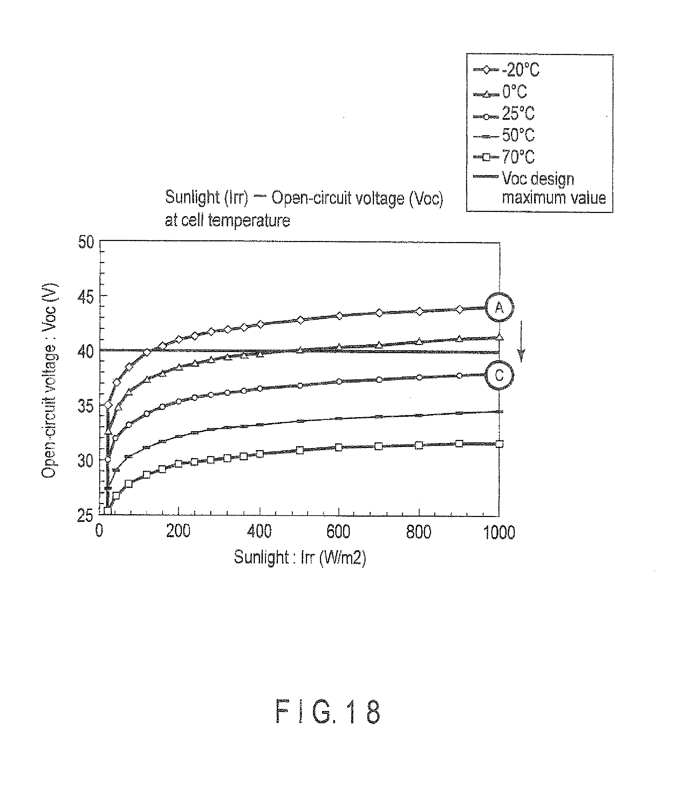

FIG. 18 is a graph showing the relationship between the amount of sunlight and an open-circuit voltage at each cell temperature of a solar battery panel. As shown in the graph, as the amount of sunlight gets smaller, the open-circuit voltage gets lower. In addition, as the cell temperature gets higher, the open-circuit voltage gets lower. In the graph, the breakdown voltage value of the open-circuit voltage is represented as 40 V.

The calculation control device 4 determines a characteristic curve of FIG. 18 from cell temperatures measured by the temperature sensor 30. Then, the present amount X of sunlight incident on the solar battery panel 2 is ascertained on the characteristic curve from the open-circuit voltages measured by the open-circuit voltage measurement device 3. Next, the calculation control circuit 4 finds the amount Y of sunlight at which the open-circuit voltage reaches the specific voltage and controls the number of solar battery panels connected to a string so that the number may be Y/X times the present number of solar battery panels.

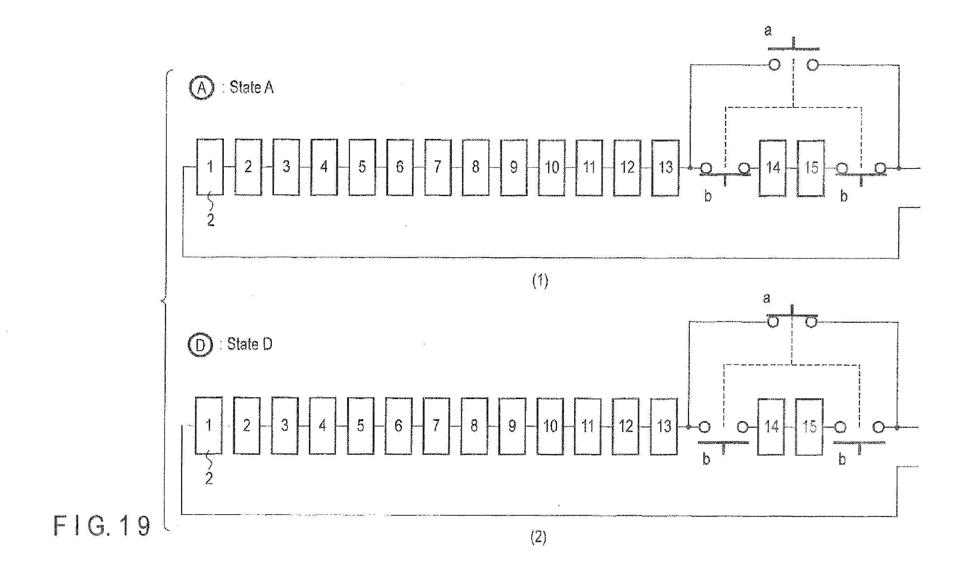

FIG. 19 is a schematic diagram showing the way the number of solar battery panels is changed by the circuit varying device 14. FIG. 19(1) shows a connection state of a string before it is changed. Before the change, the string is composed of 15 solar battery panels 2 connected in series. FIG. 19(2) shows a connection state of the string after it has been changed. After the change, the string is composed of 13 solar battery panels 2 connected in series.

The number of solar battery panels 2 connected or disconnected may be a fixed number (e.g., two) or a variable number (e.g., one to three) according to the magnitude of a voltage to be decreased. In addition, the solar battery panels to be connected or disconnected may lie in any one of the head part, middle part, and rear part of the solar battery panels connected in series.

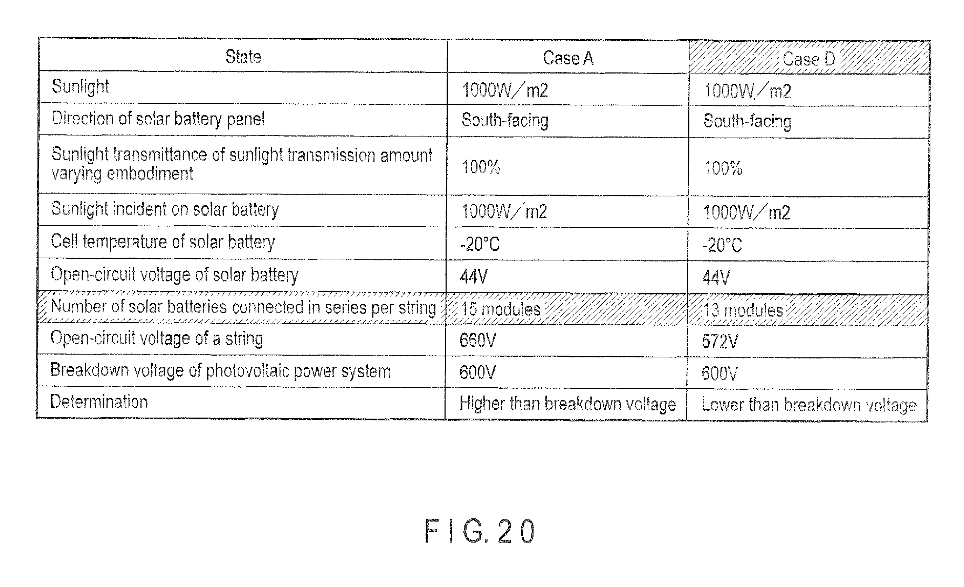

FIG. 20 shows a result obtained by applying the open-circuit voltage control system of the fourth embodiment. In case A, the amount of sunlight was at 1000 W/m², the solar battery panel faced south, and the sunlight transmittance of the sunlight transmission amount varying device was at 100%. The open-circuit voltage of the solar battery was 44 V in case A.

The open-circuit voltage of a string is calculated from the open-circuit voltage of the solar battery and the number of solar batteries connected in series per string. In case A, the amount of sunlight incident on the solar battery is 1000 W/m², the cell temperature is -20°C, and the number of solar batteries connected in series per string is 15, with the result that the open-circuit voltage of a string is 660 V. Therefore, if the breakdown voltage of the photovoltaic power system is 600 V, the open-circuit voltage has exceeded the breakdown voltage.

As in case A, in case D, the amount of sunlight was at 1000 W/m², the solar battery panel faced south, and the sunlight transmittance of the sunlight transmission amount varying device was at 100%. The circuit varying device 14 was caused to set the number of solar battery panels 2 connected to a string at 13, with the result that the open-circuit voltage of the string was at 572 V, which was within the range of a breakdown voltage of 600 V of the photovoltaic power system.

While in each of the embodiments described above, the drive control device 1 has used any one of the solar-battery-panel sunlight transmission amount varying device 11, solar-battery-panel direction varying device 12, solar-battery-panel temperature varying device 13, and circuit varying device 14, it may be configured by combining two or more of the devices suitably. Alternatively, the type of a device to be used in the drive control device 1 may be selected on a string basis.

The time that the aforementioned control operation is performed is not limited to "the time immediately before the inverter 6 starts to operate." The control operation is also performed when "the string is open" for some reason. For example, the switch 5 may be opened intentionally for maintenance or inspection. At this time, since the load is disconnected, a voltage not lower than the breakdown voltage is generated in the open string, which might damage the string 7, solar battery panel 2, or the like. Even in such a case, the open-circuit voltage control system 10 operates so that the voltage generated in the string may not exceed the breakdown voltage. Then, when the disconnected load has been connected after the completion of the maintenance, a voltage higher than the breakdown voltage will never be applied to the photovoltaic power system because the control operations described in each of the above embodiments are performed.

### [Modes of variations]

Variations of the configuration of each of the embodiments will be explained.

While in FIG. 2, the calculation control device 4 has acquired information on the open/closed state of the switch 5 from the inverter 6, it is not limited to this.

For example, the calculation control device 4 may monitor the voltage measured by the open-circuit voltage measurement device 3, determine that a load has been applied to the inverter 6 when the voltage has dropped rapidly, and stop the control operation. That is, the calculation control device 4 determines the open/closed state of the switch 5 on the basis of the voltage measured by the open-circuit voltage measurement device 3.

In addition, the calculation control device 4 acquires the state of the switch 5 in the form of a digital input (DI) and monitors the DI, making it possible to acquire the open/closed state of the switch 5.

Furthermore, a person may instruct manually a calculation device to start and stop control. That is, a person may give an instruction to cause the switch 5 to be connected or open. Particularly in a case where the inverter 6 and a string are disconnected from each other for maintenance or inspection work and then are caused to perform control after the work has been completed, facilities can be operated flexibly.

These modes of variations can be combined suitably with each of the embodiments for use in an arbitrary situation.

The functions explained in each of the above embodiments can be realized not only by configuring them in hardware but also by causing a computer to read a program in which each function has been written in software. In addition, each function may be configured to selectively use either software or hardware as needed.

Therefore, the processes written and explained in the form of flowcharts can be configured to realize the processes in hardware.

This invention is not limited to the above embodiments and, in the present or future implementation phase, may be practiced or embodied by modifying the disclosed components without departing from the spirit or character thereof.

Various inventions can be produced by combining suitably a plurality of components disclosed in the embodiments. For example, some may be removed from all of the disclosed components shown in the embodiments. In addition, the disclosed components of different embodiments may be combined suitably.

## Claims

1. An open-circuit voltage control system which is used in a photovoltaic power system that comprises a string that includes solar battery panels connected in series and a switch that connects and disconnects a path for supplying a direct-current voltage generated at the string to a load and which controls an open-circuit voltage of the string, the open-circuit voltage control system **characterized by** comprising:
an open-circuit voltage measurement device which measures an open-circuit voltage of the string in an open state where the string and the load are not connected to each other;
a drive control device which controls an output voltage from the solar battery panels; and
a calculation control device which outputs a signal for controlling the drive control device so that the open-circuit voltage may reach a specific voltage value not lower than an operable voltage of the load but lower than a breakdown voltage of the photovoltaic power system based on the open-circuit voltage measured by the open-circuit voltage measurement device, with the string and the load being in the open state.

2. The open-circuit voltage control system of Claim 1, **characterized in that**
the drive control device is a sunlight amount varying device which changes the amount of sunlight incident on the solar battery panels, and
the calculation control device outputs, to the sunlight amount varying device, a signal for changing the amount of sunlight so that an open-circuit voltage generated at the string may reach the specific voltage value based on an open-circuit voltage measured by the open-circuit voltage measurement device.

3. The open-circuit voltage control system of Claim 1, **characterized in that**
the drive control device is a direction varying device which changes at least one of the azimuth direction and inclination of the surface of the solar battery panels, and
the calculation control device outputs, to the direction varying device, a signal for changing at least one of the azimuth direction and inclination of the surface of the solar battery panels so that an open-circuit voltage generated at the string may reach the specific voltage value in terms of the relationship between the direction of sunlight and an open-circuit voltage based on an open-circuit voltage measured by the open-circuit voltage measurement device.

4. The open-circuit voltage control system of Claim 1, **characterized by** further comprising
a thermometer which measures a temperature of the solar battery panels and in that
the drive control device is a temperature varying device which changes the temperature of the solar battery panels, and
the calculation control device outputs, to the temperature varying device, a signal for changing a cell temperature so that an open-circuit voltage generated at the string may reach the specific voltage value in terms of the relationship between the cell temperature and an open-circuit voltage based on an open-circuit voltage measured by the open-circuit voltage measurement device.

5. The open-circuit voltage control system of Claim 1, **characterized in that**
the drive control device is a circuit varying device which changes the number of the solar battery panels connected in series, and
the calculation control device outputs, to the circuit varying device, a signal for changing the number of the solar battery panels connected so that an open-circuit voltage generated at the string may reach a voltage value in a specific range that is not lower than an operable voltage of the load but lower than a breakdown voltage of the photovoltaic power system in terms of the relationship between the number of the solar battery panels connected in series and an open-circuit voltage based on an open-circuit voltage measured by the open-circuit voltage measurement device.

6. The open-circuit voltage control system of Claim 1, **characterized by** further comprising
a thermometer which measures a temperature of the solar battery panels and in that
the drive control device is a sunlight amount varying device which changes the amount of sunlight incident on the solar battery panels, and
the calculation control device outputs, to the sunlight amount varying device, a signal for changing the amount of sunlight so that an open-circuit voltage generated at the string may reach the specific voltage value in terms of the relationship between sunlight and an open-circuit voltage at the cell temperature based on an open-circuit voltage measured by the open-circuit voltage measurement device and the cell temperature.
